# EUROPEAN PATENT APPLICATION

(11) **EP 4 745 763 A1**
(43) Date of publication of application: **20.05.2026**
(21) Application number: 25213895.3
(22) Date of filing: 06.11.2025
(51) Int. Cl.: G06F 8/65

(54) **READ ONLY MEMORY (ROM) PATCHING**

(30) Priority: 18.11.2024 US 202418951055
(71) Applicant: NXP B.V., 5656 AG Eindhoven (NL)
(72) Inventor: Folwarczny, Artur, 5656AG Eindhoven (NL); Cioni, Filippo, 5656AG Eindhoven (NL); Kelly, Aaron, 5656AG Eindhoven (NL)
(74) Representative: Krott, Michel

(57) **Abstract**

A read-only memory (ROM) receives an instruction address from a requestor and provides a fetched instruction from the instruction address. A ROM patcher includes storage circuitry to store a bank of entries, each entry having a corresponding bank address and is configurable as either a patch address entry or a patch replacement entry. A first entry of the bank is configured as a first patch address entry storing address information indicating a first range of ROM addresses for a first patch of instructions. A plurality of entries of the bank following the first entry are configured as a plurality of patch replacement entries, each storing a replacement instruction of the first patch. Control circuitry determines if the instruction address hits in the bank, and when it does, the replacement instruction from one of the plurality of patch replacement entries is returned to the requestor in place of the fetched instruction.

## Description

### Background

### Field

This disclosure relates generally to memories, and more specifically, read only memory (ROM) patching.

### Related Art

In many applications, read only memories (ROMs) are used to store code or other information for use within a data processing system. Once programmed, it is not possible to change the information within the ROM, such as to update or correct code. Therefore, in one solution, a fixed size additional memory is used to store pairs of a patchable ROM address and corresponding replacement instruction. In such a solution, each replacement instruction requires a corresponding patchable ROM address, however, this results in an inefficient use of the additional memory space. Therefore, a need exists for ROM patching with improved efficiency so as to increase coverage without increasing the memory size requirements.

### Brief Description of the Drawings

The present invention is illustrated by way of example and is not limited by the accompanying figures, in which like references indicate similar elements. Elements in the figures are illustrated for simplicity and clarity and have not necessarily been drawn to scale.
FIG. 1 illustrates, in block diagram form, a data processing system having a read only memory (ROM) and a corresponding ROM patcher, in accordance with one embodiment of the present invention.
FIG. 2 illustrates, in block diagram form, a more detailed view of the ROM patcher between the ROM and CPU of FIG. 1, in accordance with an embodiment of the present invention.
FIG. 3 illustrates, in diagrammatic form, different layouts for the register bank of the ROM patcher of FIG. 2, in accordance with various embodiments of the present invention.
FIG. 4 illustrates, in diagrammatic form, a patch address word within the register bank of the ROM patcher, in accordance with one embodiment of the present invention.
FIG. 5 illustrates, in partial schematic and partial block diagram form, a more detailed view of the ROM patcher of FIG. 2, in accordance with one embodiment of the present invention.

### Detailed Description

In one aspect, in a data processing system having a ROM and a processor, each coupled to a system interconnect, a ROM patcher resides between the ROM and the system interconnect so that the ROM patcher is capable of monitoring the addresses provided to the ROM and selectively replacing the return data element from the ROM with a replacement data element (in which each data element can represent a replacement instruction or replacement data). In one embodiment, assuming the ROM stores instructions fetched by the processor, the ROM patcher includes a register bank configured to store one or more instruction addresses of the ROM, along with one or more replacement instructions for each of the stored instruction addresses. In this manner, when a ROM address for an instruction fetch provided by the processor to the ROM matches a range of stored patchable addresses in the register bank, the ROM patcher selects an appropriate replacement instruction from the register bank corresponding to the range of patchable addresses to return to the processor in response to the instruction fetch rather than returning the instruction stored in the ROM. At boot, the register bank can be initialized via a private bus or via another direct connection to the register bank. In one embodiment, for each range of patchable ROM addresses, the register bank is capable of storing one or more replacement instructions. In this manner, the register bank need not store a ROM address corresponding to each and every replacement instruction, thus allowing for improved configurability of the ROM patcher and improved use of the patch register bank.

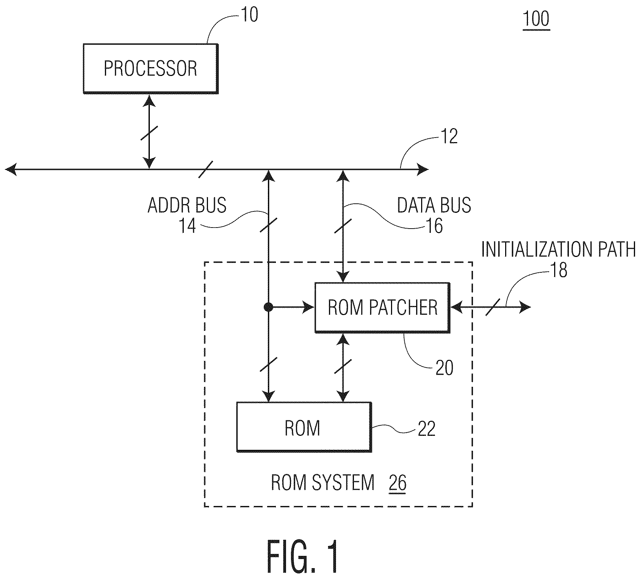

FIG. 1 illustrates, in block diagram form, a data processing system 100, in accordance with an embodiment of the present invention. System 100 includes a processor 10, a system interconnect 12, and a ROM system 26, in which ROM system 26 includes a ROM 22, and a ROM patcher 20. Processor 10 is bidirectionally coupled to system interconnect 12, and ROM system 26 is bidirectionally coupled to system interconnect 12 via an address bus 14 and a data bus 16. Each of ROM 22 and ROM patcher 20 are coupled to address bus 14, ROM patcher 20 is coupled to system interconnect 12 via data bus 16, and ROM 22 is coupled to ROM patcher 20. Note that processor 10 can be any type of processor, such as, for example, a central processing unit (CPU). System interconnect 12 can be any type of system interconnect such as a system bus, a cross bar switch, and interconnect fabric, etc. Regardless of how system interconnect 12 is implemented, ROM patcher 20 is configured to monitor addresses on address bus 14 and to intercept data returned from ROM 22 so as to selectively provide replacement data to system interconnect 12 rather than the data returned from ROM 22.

Although ROM 22 may store any type of information, such as instructions or data values (in which the data values may include, e.g., operands, table values, operation values, results, etc.), it will be assumed, for ease of description, that ROM 22 stores instructions (i.e. code) and therefore, ROM patcher 20 intercepts instructions returned from ROM 22 so as to selectively provide replacement instructions back to system interconnect 12. Since processor 10 can request or fetch information (e.g. instructions) from ROM 20, processor 10 may also be referred to as a requestor or requesting device. Also, although FIG. 1 has been illustrated as including a processor and a ROM system, note that, in alternate embodiments, system 100 may include additional elements, such as additional memories, additional processors or other requestors capable of requesting information from ROM 20 or any other memory, other modules or peripherals, etc.

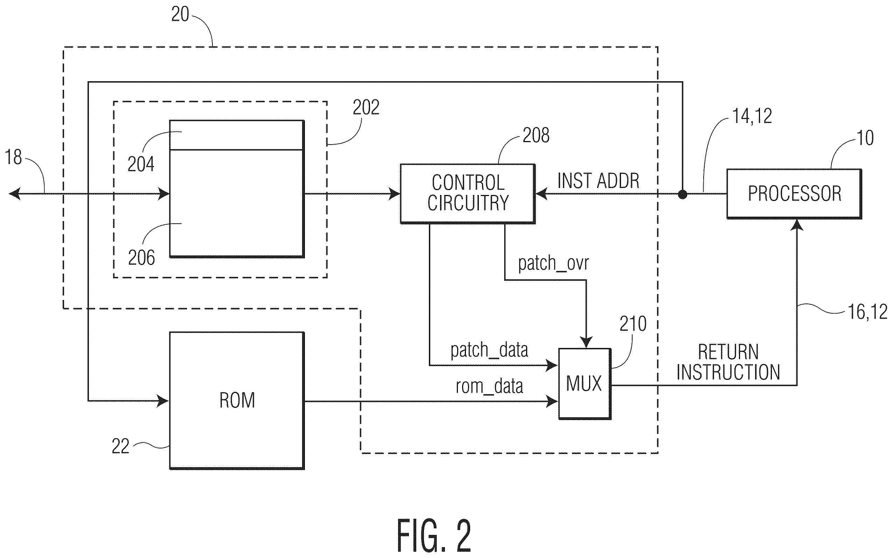

FIG. 2 illustrates, in block diagram form, a more detailed view of ROM patcher 20 of FIG. 1, coupled between ROM 22 and processor 10, in accordance with one embodiment of the present invention. ROM 22 receives read access addresses (e.g. read instruction addresses) from processor 10 via system interconnect 12 and address bus 14, and ROM 22 provides return data (e.g. instructions) from the read access addresses as ROM_data. ROM patcher 20 includes storage circuitry 202 which includes a configuration entry 204 and a set of patch entries 206, in which each patch entry can be configured as a patch address entry or patch instruction entry. In one embodiment, storage circuitry 202 is implemented as a bank of registers (and therefore may be referred to as register bank 202 which includes configuration register 204 and set of patch registers 206). In this embodiment, each patch entry may be referred to as a patch register, in which each patch register can be configured as either a patch address register or patch instruction register. Note that, in alternate embodiments, although illustrated in FIG. 2 as a bank of registers, storage circuitry 202 can be implemented with any type of storage circuitry, such as any type of memory or registers, fuses, etc. Storage circuitry 202 may include additional circuitry, as needed, to write to the entries or registers, and is capable of receiving information for storage into the registers via an initialization path 18. For the descriptions herein, storage circuitry 202 will be referred to as register bank 202. In one embodiment, initialization path 18 can be accessed by processor 10, other elements of system 100 (such a security subsystem of system 100), or via external pins to initialize register bank 202.

In addition to register bank 202, ROM patcher 20 includes an override multiplexer (MUX) 210 and control circuitry 208. MUX 210 receives patch_data at a first data input, ROM_data at a second data input, and a patch override signal (patch_ovr) at a control input. ROM 22 receives an access address, such as an instruction fetch address (i.e. INST ADDR) corresponding to a fetch request, via system interconnect 12 and address bus 14 from processor 10. In return, ROM 22 provides a fetched instruction from the fetch address as ROM_data to the second data input of MUX 210. (Note that the fetched instructions from ROM 22 provided to MUX 210 as ROM_data may also be referred to as patchable instructions.) Control circuitry 208 is configured to monitor the access addresses (e.g. fetch addresses) on instruction bus 14. In response to each monitored address, control circuitry 208 determines whether or not the monitored address matches a range of patch addresses within register bank 202. If it does not (i.e. if the monitored address misses in bank 202), then patch_ovr is negated such that the fetched instruction provided as ROM_data from ROM 22 to the second input of MUX 210 is returned as the return instruction back to processor 10 in response to the fetch request. However, if the monitored address matches a range of patch addresses within register bank 202 (hits within bank 202), control circuitry 208 provides a patch instruction (i.e. replacement instruction) from register bank 202 as patch_data to the first input of MUX 210, and patch_ovr is asserted such that the patch instruction from register bank 202 is returned as the return instruction via override MUX 210 back to processor 10 in response to the fetch request. That is, in this situation, the patch instruction from bank 202 overrides (i.e. replaces) the fetched patchable instruction from ROM 22.

Note that once ROM patcher 20 is enabled, ROM system 26 operates transparently for accesses to ROM 22 in that, from the perspective of the requestor, there is no difference in timing for the returned instruction, regardless of whether it was provided by ROM 22 or bank 202. In one embodiment, control circuitry 208 and override MUX 210 are implemented with combinatorial logic to substitute original data (e.g. original instructions) with patch data (e.g. replacement instructions) at runtime. In this manner, ROM patcher 20 also does not introduce additional latency (i.e. introduces no additional clock cycles) to the ROM access time. In one embodiment, additional sequential logic is included with the combinatorial logic, such as one or more register stages, in order to match the timing of the ROM.

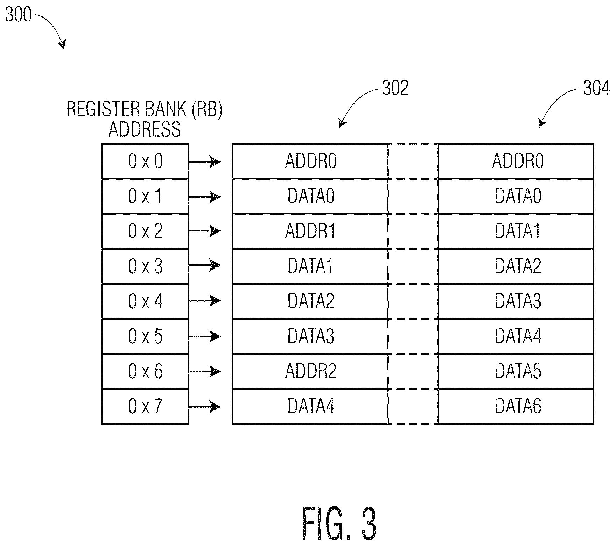

FIG. 3 illustrates, in diagrammatic form, example layouts for a patch register bank (such as bank 202 of FIG. 2), in accordance with an embodiment of the present invention. In the illustrated embodiment, it is assumed that the patch register bank includes 8 patch registers, in which each patch register can be configured as a patch address register (ADDRx) or a patch instruction register (DATAy), in which x is the index of patch address registers starting with 0 up to 3, and y is in the index of the patch instruction registers starting with 0 up to 6. Column 300 includes the register bank address of each register within the register bank. Since there are 8 registers, the register bank addresses are numbered from 0x0 (=b000) to 0x7 (=b111), in which, as used herein, a "0x" preceding a number indicates the number is in hexadecimal form and a ""b" preceding a number indicates the number is in binary form. Therefore, in the illustrated embodiment, a 3-bit address value is sufficient to address the 8 registers of the bank.

Column 302 illustrates a first example of an 8-register bank in which the first, third, and seventh patch registers (at 0x0, 0x2, and 0x6, respectively) are configured as patch address registers and the second, fourth, fifth, sixth, and eight patch registers (at 0x1, 0x3, 0x4, 0x5, and 0x7, respectively) are configured as patch instruction registers. Each patch address register (i.e. patch address entry) indicates a range of patch address of ROM 22, in which a range of patch addresses can refer to a range of one or more addresses. In the case a patch address register indicates a range of one address, it simply indicates a single address. In the example of column 302 of FIG. 3, each of ADDR0 and ADDR2 indicate a single patch address (i.e. a range of one patch address), and ADDR1 indicates a range of three patch addresses. Column 304 of FIG. 3 illustrates a second example in which only the first patch register corresponds to an patch address register (at 0x0), and the remaining 7 patch registers corresponds to patch instruction registers which store a patch of 7 consecutive instructions. In the example of column 304, ADDR0 indicates a range of 7 patch addresses.

Each patch address register (i.e. patch address entry), is immediately followed by one or more corresponding patch instruction registers (i.e. patch instruction entries), with one patch instruction register for each patch address in the range of patch addresses indicated by the patch address register. As will be described in more detail below, an instruction located at a location of ROM 22 which falls within the range indicated by a patch address register is to be replaced with a patch instruction located in the one or more corresponding patch instruction registers. The one or more replacement instructions may be referred to as a patch of instructions, and if there is more than one instruction in the patch of instructions, the instructions must be consecutive (e.g. located at consecutive address locations in ROM 22 and are therefore executed consecutively) and must be stored in the same order as the original instructions in ROM 22. Note that each patch address register along with its one or more corresponding patch instruction registers can be stored in any order within the bank (so long as the order of instructions within the patch of instructions is maintained). For example, ADDR1 may be located before ADDR0.

In operation, using column 302 as an example layout for bank 202, when an instruction fetch to an address in ROM 22 hits in bank 202 (i.e. matches the ranges of patch addresses specified by ADDRO, ADDR1, or ADDR2) a corresponding replacement instruction is returned instead of the instruction stored in ROM 22. For example, if an instruction fetch address matches the single address indicated by ADDRO, then the instruction stored in DATA0 is returned rather than the instruction stored in ROM 22. Similarly, if an instruction fetch address matches (i.e. falls within) the range of addresses specified by ADDR1, then the instruction stored in one of DATA1-DATA3 is returned rather than the instruction stored in ROM 22. In the case of multiple consecutive instructions, it is determined which of the consecutive instructions to return based on the received instruction fetch address. Note also that random access is still preserved, in that a jump to a patch instruction in the middle of the patch of consecutive instructions is still supported, without executing previous instructions within the patch. In this manner, note that bank 202 implements a 1:N scheme in which, if there is a consecutive block of N replacement instructions to be specified, only one patch address register is required to do so (e.g. by specifying the address range of the block of N replacement instructions). However, in one embodiment, if a patch crosses a prefix boundary, the patch is split into two in which an extra patch address would also need to be specified for the split patch. Also, in one embodiment, the ranges of patch addresses specified by the patch address registers of bank 202 cannot overlap. Note that, in one embodiment, the values in bank 202 are configurable at run-time, such as during the boot-up process, via initialization path 18.

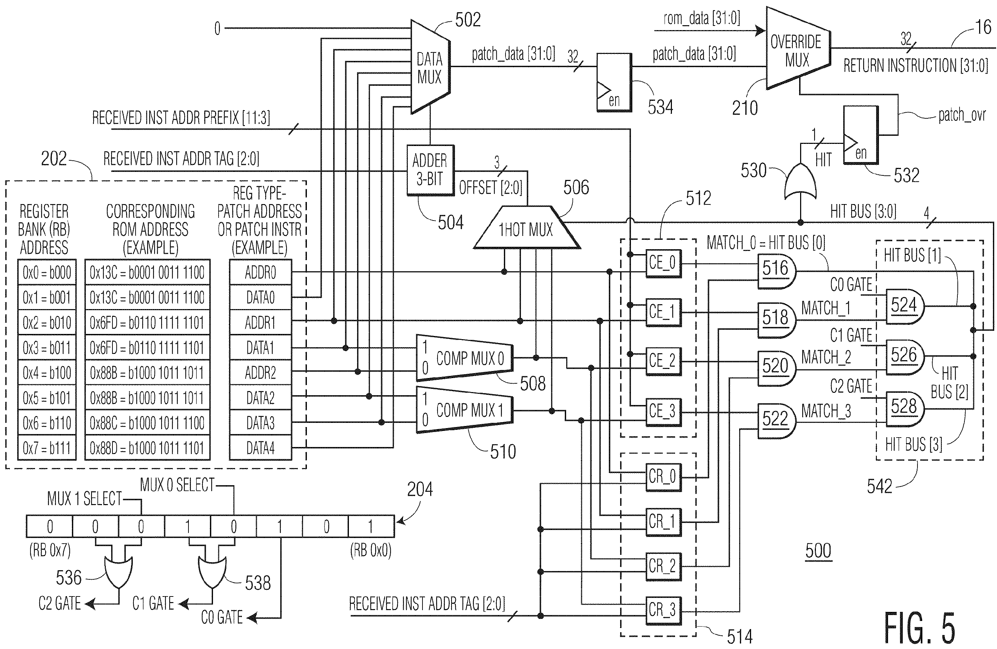

In one embodiment, as will be described in reference to FIG. 5, configuration register 204 is configured to specify whether a register in bank 202 is a patch address register or a patch instruction register. Configuration register 204 includes a reg_num number of bits, in which each register of bank 202 has a corresponding configuration bit (also referred to as a configuration indicator) in configuration register 204. Therefore, reg_num is equal to the number of registers in bank 202 (e.g. 8 for the layout examples of FIG. 3). When the corresponding configuration bit of a register in bank 202 is set to a first value (e.g. one), then the register is defined as a patch address register, otherwise, when the corresponding bit is set to a second value (e.g. zero), then the register is defined as a patch instruction register.

In one embodiment, each instruction address received by ROM patcher 20 via address bus 14 is split (i.e. parsed) by ROM patcher 20 into an address prefix and an address tag. The address tag is log₂(reg_num) bits wide (corresponding to the least significant bits (LSBs) of the instruction address), while the address prefix uses the remaining bits (corresponding to the remaining most significant bits (MSBs) of the instruction address). Therefore, in the examples herein with reg_num=8, tag bits = log₂(8) = 3 bits, and prefix bits are the instruction address bits without the tag bits (instruction address bits - tag bits). In the example herein, it is assumed that each instruction address is 12 bits, such that prefix bits = 12-3 = 9 bits.

In order to determine whether a received instruction address matches (i.e. hits) an instruction patch (defined by an address range) in bank 202, ROM patcher 20 is configured to determine if the parsed prefix of the received instruction address matches a prefix of any patch address register of bank 202, and if so, a prefix hit is indicated. Next, ROM patcher 20 is configured to, if a prefix hit occurs, check if the parsed tag of the received instruction falls within the address range of any of the patches in bank 202. If so, a tag hit is indicated. If both a prefix hit and tag hit occur at the same index (at the same register bank address for the same patch), the patch_ovr is asserted and data from bank 202 is interposed onto data bus 16 (e.g. a patch instruction from bank 202 is interposed onto data bus 16, replacing the fetched instruction from ROM 22). Note that all instructions in a patch of instructions in bank 202 correspond to ROM locations which have the same address prefix. For this reason, if a patch of instructions crosses a prefix boundary, the patch is split into two patches, as described above, resulting in the need to use an additional register of bank 202 as a patch address register. That is, a patch of instructions cannot contain replacement instructions with corresponding ROM addresses of differing prefixes.

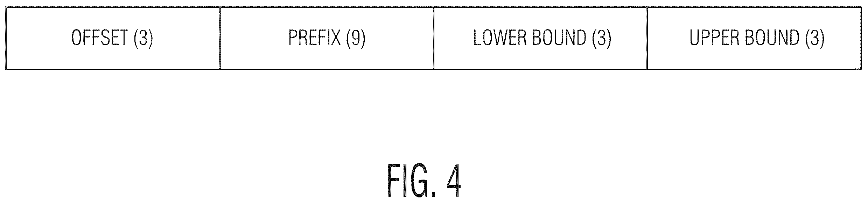

FIG. 4 illustrates, in diagrammatic form, the layout of a patch address register of bank 202, in accordance with an embodiment of the present invention, in which each patch address register of bank 202 identifies an address range of ROM 22 for a corresponding patch and is followed by one or more patch instruction registers, each containing a replacement instruction for the corresponding patch. In one embodiment, each patch address register corresponds to a different patch base address, in which the base address of a patch corresponds to the first (i.e. starting) instruction address of the patch in ROM 22. For the illustrated embodiment, it is assumed that each instruction address is 12 bits, with the tag bits being 3 (LSB) bits and the prefix bits being 9 (MSB) bits. Each register of bank 202 configured as a patch address register includes multiple bit fields configured to store address information including a patch offset (which is the same width as the tag bits, e.g., 3 in the illustrated embodiment), a patch prefix (which is the same width as the prefix bits, e.g., 9 in the illustrated embodiment), a patch lower bound, and a patch upper bound (in which each of the lower and upper bounds are the same width as the tag bits, e.g., 3). The patch offset indicates the difference between the register bank address (i.e. entry bank address) of the first corresponding instruction register and the tag bits of the corresponding patch base address (i.e. register bank address of the first corresponding patch instruction register minus the tag bits of the corresponding base address). The patch prefix indicates the prefix bits of the corresponding patch base address. The lower and upper bounds indicate the tag bits of the first (i.e. starting) patch instruction register of the corresponding patch and the last (i.e. ending) patch instruction register of the corresponding patch, respectively. That is, the lower and upper bounds correspond to the tag bits of the starting ROM address for the patch and the ending ROM address for the patch, respectively. Therefore, note that the patch prefix in combination with the patch lower bound provides to the corresponding base address. Note that, in alternate embodiments, more or different fields may be used in a patch address register to indicate the information. For example, rather than a lower and upper bound, the patch address registers can define an address range of ROM 22 for a corresponding patch differently.

FIG. 5 illustrates, in partial block diagram and partial schematic form, a more detailed view of ROM patcher 20, in accordance with an embodiment of the present invention. In the illustrated embodiment, an example is provided with 8 registers for register bank 202 in which the first (i.e. further left) column indicates the corresponding register bank (RB) addresses. The third (i.e. furthest right) column labeled REG TYPE indicates whether each register is configured as either a patch address register type or a patch instruction register type. As indicated by the REG TYPE, the first, third, and fifth registers (corresponding to RB addresses 0x0, 0x2, and 0x4) are configured as patch address registers and the remaining registers are configured as patch instruction registers. In the illustrated example, ADDR0 (which indicates a range of one address) is followed by a corresponding patch instruction register DATA0 which defines a patch with one instruction, ADDR1 (which also indicates a range of one address) is followed by a corresponding patch instruction register DATA1 which defines a patch with one instruction, and ADDR3 (which indicates a range of three address) is followed by corresponding patch instruction registers DATA2, DATA3, and DATA4 which define a patch with three consecutive instructions. The second (i.e. middle) column provides corresponding ROM addresses for each register, in accordance with an example of the illustrated embodiment. For each patch instruction register, the corresponding ROM address indicates the instruction address of the patch instruction, and for each patch address register, the corresponding ROM address indicates the base address of the corresponding patch. For example, for the patch address register ADDR2 (at RB 0x4), the base address is b1000 1011 1011. For DATA2-DATA4, the instruction addresses for the replacement instructions are therefore b1000 1011 1011, b1000 1011 1100, and b1000 1011 1101, in which they correspond to consecutive address locations and the address corresponding to the first instruction of the patch at DATA2 is the same as the base address. The example values of register bank 202 of FIG. 5 will be used to describe operation of FIG. 5 below.

Also illustrated in FIG. 5 is configuration register 204 with example values corresponding to the example configuration of register bank 202 described in the previous paragraph. Configuration register 204 includes 8 bits, in which the furthest right bit is the configuration bit for RB 0x0, and the furthest left is the configuration bit for RB 0x7. A "1" indicates the corresponding register of bank 202 is configured as a patch address register and a "0" indicates it is a patch instruction register. Therefore, from the right to the left, the first, third, and fifth bits of configuration register 204 are set to 1 to indicate that the registers at 0x0, 0x2, and 0x4 are configured as patch address registers, and the remaining as patch instruction registers. The control circuitry (e.g. control circuitry 208) of ROM patcher 20 in FIG. 5 includes a data multiplexer 502, an adder 504, a 1HOT MUX 506, comparator (COMP) MUXes 508 and 510, equality comparators 512 (including CE_0, CE_1, CE_2, and CE_3), range comparators 514 (including CR_0, CR_1, CR_2, and CR_3), AND gates 516, 518, 520, 522, 524, 526, and 528, and OR gates 530, 536, and 538. The control circuitry is coupled to override MUX 210 via registers 534 and 532 to ensure that data is returned with proper timing from ROM system 26 back to processor 10.

ROM patcher 20 is configured to receive an instruction address via address bus 14, which is parsed into the 9-bit prefix (labeled as RECEIVED INST ADDR PREFIX[11:3]) and the 3-bit tag (labeled as RECEIVED INST TAG[2:0]). The RECEIVED INST ADDR PREFIX is provided to equality comparators 512, and the RECEIVED INST ADDR TAG is provided to a first input of adder 504 and to range comparators 514. A second input of adder 504 is coupled to receive a 3-bit offset value from 1HOT MUX 506, and an output of adder 504 provides the sum of its inputs as a select signal to a control input of DATA MUX 502. Data MUX 502 has a data input coupled to each register of register bank 202 to receive the 32-bits of the corresponding register, except for the first bank (which must be configured as a patch address register and thus cannot be a patch instruction register), and an output coupled to provide the contents of a selected register as patch_data[31:0]. The selected register corresponds to the register whose register bank address is indicated by the 3-bit input from adder 504. (Note that, in the illustrated embodiment, each register in bank 202 is assumed to have 32-bits, because each instruction returned from ROM system 26 is a 32-bit instruction, however, in alternate embodiments, the registers of bank 202 may be smaller or larger, as needed, based on the size of the return instruction or return data.)

Each equality comparator of comparators 512 is a 9-bit comparator which receives the RECEIVED INST ADDR PREFIX [11:3] at a first input, and the 9-bit prefix field of a corresponding register of bank 202, in which an output of the comparator is asserted to a logic level one if the two 9-bit values match, and negated to a logic level zero otherwise. Note that the corresponding register will only have a valid 9-bit prefix field if it is configured as a patch address register (as opposed to a path instruction register), therefore, the corresponding match indicators based on the comparators are gated from providing a match result, as needed, by gating logic 542 (including AND gates 524, 526, and 528, whose operation will be described in more detail below).

Each range comparator of comparators 514 is a 3-bit range comparator which receives the RECEIVED INST ADDR TAG[2:0] at a first input, and the 3-bit patch upper bound field/ 3-bit patch lower bound field of a corresponding register of bank 202 at a second and third input. An output of the range comparator is asserted to a logic level one if the first input is within the range defined by the second and third inputs (i.e. is both >= the lower bound and <= the upper bound) and negated to a logic level zero otherwise. Therefore, note that a TAG is considered to match (i.e. hit) the range defined by the upper and lower bounds if "lower bound >= TAG <= upper bound." As described above, note that the corresponding register will only have valid 3-bit upper and lower bound fields if it is configured as a patch address register, therefore, the corresponding match indicators based on the range comparators are gated from providing a match result, as needed, by gating logic 542 (as will be described in more detail below).

The outputs of the equality comparators (CE_0 - CE_3) and range comparators (CR_0 - CR_3) are combined with corresponding AND gates 516, 518, 520, and 522, such that the output of a corresponding AND gate is asserted to a logic level high only if both the RECEIVED INSTR ADDR PREFIX and RECEIVED INSTR ADDR TAG match the prefix field and range defined by the upper and lower bound fields of the same corresponding register of bank 202, respectively. AND gate 516 receives the output of CE_0 at a first input and the output of CR_0 at a second input, and outputs a match_0 indicator. AND gate 518 receives the output of CE_1 at a first input and the output of CR_1 at a second input, and outputs a match_1 indicator. AND gate 520 receives the output of CE_2 at a first input and the output of CR_2 at a second input, and outputs a match_2 indicator. AND gate 522 receives the output of CE_3 at a first input and the output of CR_3 at a second input, and outputs a match_3 indicator.

The match indicators are used in combination with configuration registers 204 by gating logic 542 to generate corresponding hit signals (HIT BUS[3:0]). In the illustrated embodiment, note that the corresponding prefix and tag fields of RB 0x0 of bank 202 are provided to CE_0 and CR_0, and the corresponding prefix and tag fields of RB 0x2 are provided to CE_1 and CR_1. However, the contents of RB 0x3 and RB 0x4 are provided as inputs to COMP MUX 0 508 in which one of these is selected to provide the corresponding fields of a corresponding register to CE_2 and CR_2. Similarly, one of RB 0x5 and RB 0x6 provides the corresponding fields of a corresponding register to CE_3 and CR_3 via COMP MUX 1 510. The select signals of MUX 0 508 and MUX 1 510 are provided by configuration register 204.

Since two registers of bank 202 which are immediately adjacent each other cannot both be configured as patch address registers (because each patch address register is followed by at least one patch instruction register), it can be assumed that only one of RB 0x3 and RB 0x4 can be a patch address register and that only one of RB 0x5 and RB 0x6 can be a patch address register. Therefore, for MUX 0 508, the configuration bit of configuration register 204 corresponding to RB 0x3 is used as the select signal such that, if the configuration bit is 0, then RB 0x3 is configured as a patch instruction register, so MUX 0 508 instead provides RB 0x4 as the corresponding register to CE_2 and CR_2. Otherwise, if the configuration bit is a 1, then RB 0x3 is configured as a patch address register such that MUX 0 508 provides RB 0x3 as the corresponding register to CE_2 and CR_2. Similarly, for MUX 1 510, the configuration bit of configuration register 204 corresponding to RB 0x5 is used as the select signal such that, if the configuration bit is 0, then RB 0x6 is configured as a patch instruction register, so MUX 0 508 instead provides RB 0x5 as the corresponding register to CE_3 and CR_3. Otherwise, if the configuration bit is a 1, then RB 0x5 is configured as a patch address register such that MUX 1 510 provides RB 0x5 as the corresponding register to CE_3 and CR_3.

With respect to the match indicators, gating logic 542 is used to generate the appropriate hit signals, in which the output of AND gates 518, 520, and 522 are gated (i.e. disabled or masked) based on configuration register 204 since not all registers of bank 202 are configured as patch address registers. Note that RB 0x1 and RB 0x7 are not provided to an equality comparator of comparators 512 nor to any range comparator of comparators 514 because it is not possible for these particular registers to be configured as patch address registers (since RB 0x1 must be a patch instruction register corresponding to the patch address register of RB 0x0, and RB 0x7 can only be a patch instruction register since it is the last register in bank 202, meaning no additional patch instruction register can follow it). Due to these aspects of bank 202 which can be assumed, each of comparators 512 and comparators 514 need only include reg_num/2 comparators rather than reg_num comparators. Also, since it can be assumed that RB 0x0 is a patch address register, the output of AND gate 516 (corresponding to CE_0 and CR_0) is not gated such that match_0 is provided directly as HIT BUS[0]. HIT BUS[0], if asserted to a logic level one, indicates that a hit occurred with RB 0x0.

With respect to RB 0x2, it can be configured as either a patch address register or patch instruction register, in which the configuration bit for RB 0x2 is provided as C0 gate to a first input of AND gate 524 and match_1 is provided as the second input to AND gate 524. In this manner, if RB 0x2 is configured as a patch address register, the value of C0 gate is a logic level one, allowing the value of match_1 to be provided as HIT BUS[1]. HIT BUS[1], if asserted to a logic level one, indicates that a hit occurred with RB 0x2. Otherwise, if HIT BUS[1] is negated to a logic level zero, it indicates that either a miss occurred with RB 0x2 or that RB 0x2 is configured as a patch instruction register which is not used to determine a hit/miss.

With respect to RB 0x3 and RB 0x4, at most, only one can be configured as a patch address register. As described above, the configuration bit for RB 0x3 selects which register to provide via COMP MUX 0 508 as the selected corresponding register to CE_2 and CR_2. In this case, the configuration bits for RB 0x3 and 0x4 are ORed together by OR gate 538 and provided as C1 gate to a first input of AND gate 526, and match_2 is provided as a second input to AND gate 526. If either of RB 0x3 or RB 0x4 is configured as a patch address register, then C1 gate is asserted to a logic level one, allowing the value of match_2 to be provided as HIT BUS[2]. HIT BUS[2], if asserted to a logic level one, indicates that the selected one of RB 0x3 or RB 0x4 is configured as a patch address register and that a hit occurred with the selected register. Otherwise, if HIT BUS[2] is negated to a logic level zero, it indicates that either a miss occurred with the selected one of RB 0x3 and RB 0x4 or that RB 0x3 and RB 0x4 are configured as patch instruction registers which are not used to determine hits/misses.

With respect to RB 0x5 and RB 0x6, at most, only one can be configured as a patch address register. As described above, the configuration bit for RB 0x5 selects which register to provide via COMP MUX 1 510 as the selected corresponding register to CE_3 and CR_3. In this case, the configuration bits for RB 0x5 and 0x6 are ORed together by OR gate 536 and provided as C2 gate to a first input of AND gate 528, and match_3 is provided as a second input to AND gate 528. If either of RB 0x5 or RB 0x6 is configured as a patch address register, then C2 gate is asserted to a logic level one, allowing the value of match_3 to be provided as HIT BUS[3]. HIT BUS[3], if asserted to a logic level one, indicates that the selected one of RB 0x5 or RB 0x6 is configured as a patch address register and that a hit occurred with the selected register. Otherwise, if HIT BUS[3] is negated to a logic level zero, it indicates that either a miss occurred with the selected one of RB 0x5 and RB 0x6 or that RB 0x5 and RB 0x6 are configured as patch instruction registers which are not used to determine hits/misses.

The values of HIT BUS are then used to control override MUX 210 to output the correct instruction (rom_data[31:0] fetched from ROM 22 or patch_data[31:0] from bank 202) as the return instruction[31:0] to the requestor via data bus 16. If any of the hit values is asserted to a logic level one, then occurrence of a hit is indicated, and a HIT indicator is asserted. For example, OR gate 530 has an input coupled to each bit of the HIT BUS such that if any one is asserted, the output of OR gate 530 asserts the HIT indicator at its output to a logic level one. The HIT indicator is provided via register 532 as patch_ovr to MUX 210. The value of the HIT BUS[3:0] is used to generate (via 1HOT MUX 526) the select signal for DATA MUX 502 to select the correct replacement instruction from bank 202. Note that even in the case of no hit in bank 202 (i.e. if the HIT indicator is negated to a logic level zero), HIT BUS is used to generate the select signal for DATA MUX 502, which leads to an undefined output. However, in this case, this has no effect on the system since the output of DATA MUX 502 is not selected by override MUX 210, as properly controlled by the HIT indicator.

Note that, at most, HIT BUS[3:0] should have only one asserted signal (i.e. at most only one of the hit signals should be at a logic level one). 1HOT MUX 506 is coupled to receive the 3-bit offset fields from each of RB 0x0, RB 0x2, the selected one of RB 0x3/0x4, and the selected one of RB 0x5/0x6. HIT BUS[3:0] is provided to 1HOT MUX 506 to select one of the 3-bit offset values to provide as OFFSET[2:0] to adder 504 based upon which of the hit signal of the HIT BUS is asserted, because the asserted hit signal corresponds to the patch address register which resulted in the hit. For example, if HIT BUS[3:0] = b0001, then the offset field from RB 0x0 is selected, if HIT BUS[3:0] = b0010, then the offset field from RB 0x2 is selected, if HIT BUS[3:0] = b0100, then the offset field from the selected one of RB 0x3/0x4 is selected, and if HIT BUS[3:0] = b1000, then the offset field from the selected one of RB 0x5/0x6 is selected.

Adder 504 adds OFFSET[2:0] from 1HOT MUX 506 to the RECEIVED INST ADDR TAG to obtain the proper register bank address for the replacement instruction. This register bank address is provided as the select signal to DATA MUX 502 which selects the patch instruction register from RB 0x1-0x7 to provide as patch_data[31:0]. The value of patch_data[31:0] is provided via register 534 to the second input of override MUX 210. At the appropriate time (e.g. with the next clock cycle), the values of registers 534 and 532 are provided to MUX 210 so that MUX 210 can provide the selected value as the return instruction. In the illustrated embodiment, registers 534 and 532 therefore provide an additional register stage, which is needed since ROM 22 is expected to take one cycle to output rom_data. Note that, in alternate embodiments, ROM 22 could take any number of cycles to output rom_data. Therefore, ROM patcher 20 can be adapted to include any number of registers, as needed, to match the behavior (e.g. timing) of ROM 22.

Note that patch_data[31:0] represents the correct replacement instruction assuming there was a single prefix hit and tag hit at the same register bank address. If the prefix hit and tag hit were not at the same register bank address or there were multiple prefix and tag hits at the same register bank address, the patch_data may not be the correct replacement instruction. These error conditions can be determined, for example, based on the outputs of the comparators.

In operation, for each received INST ADDR from addr bus 14, ROM patcher 20 determines whether the received INST ADDR hits within bank 202 by determining if the received INST ADDR falls within an address range identified by any of the patch address registers of bank 202. This includes comparing both the prefix and tag of the received INST ADDR to patch address registers of bank 202. For example, in one embodiment, ROM patch 20 determines whether the RECEIVED INST ADDR PREFIX hits (i.e. matches) a prefix field of any of the registers in bank 202, in which the register which results in the hit may be referred to as the hit register. (In the illustrated embodiment of FIG. 5, this is performed by comparators 512.) If a prefix hit is determined, then ROM patcher 20 determines if a tag hit occurs by determining whether the RECEIVED INST ADDR TAG hits the corresponding range of the patch defined by the hit register. (In the illustrated embodiment of FIG. 5, this is performed by comparators 514.) Therefore, if a prefix hit and tag hit both occur at the same register in bank 202, then patch_ovr is asserted so that a replacement instruction from the patch of instructions corresponding to the hit register can be sent in place of the patchable instruction fetched from ROM 22.

As an example, which uses the example values for bank 202 illustrated in FIG. 5, an instruction fetch address is received by ROM patch 20 as b1000 1011 1101 (=0x8BD). In this example, RECEIVED INST ADDR PREFIX is parsed as b100010111, and RECEIVED INST ADDR TAG is parsed as b101. In the example of FIG. 5, RB 0x4 is configured as a patch address register storing ADDR2 (specifying a range of 3 addresses), in which the patch base address for ADDR2 is b1000 1011 1011 (which is the ROM address of the first instruction of the patch located in RB 0x5, which is configured as a patch instruction address). The patch address register which stores ADDR2 (i.e. RB 0x4) has a patch offset field set to b010 (which is determined as the register bank address of the first instruction of the patch, i.e. b101, minus the tag bits of the base address, i.e. b011). Therefore, the patch offset field = b101-b011 = b010. RB 0x4 also has a patch prefix field set to b100010111, a patch lower bound field set to b011 (the tag of the first instruction of the corresponding patch, in RB 0x5), and a patch upper bound field set to b101 (the tag of the last instruction of the corresponding patch, in RB 0x7).

In this example, since the configuration bit corresponding to RB 0x3 in configuration register 204 of FIG. 5 is set to 0, COMP MUX 508 provides the prefix field bits (b100010111) from RB 0x4 (rather than RB 0x3) to CE_2. In this case, CE_2 outputs a logic level one indicating a prefix hit since the prefix bits from RB 0x4 match the RECEIVED INST ADDR PREFIX. The upper and lower bound fields of RB 0x4 are provided to CR_2, and, in this case, CR_2 outputs a logic level one indicating a tag hit since the RECEIVED INST ADDR TAG hit within the range defined by the upper and lower bounds (e.g. b101 is within the range b011-b101). Since both inputs of AND gate 520 are ones, match_2 is asserted to a one. Since the configuration bit for RB 0x4 is one, HIT BUS[2] at the output of AND gate 526 is asserted to a logic level one (while the remining hit signals remain a logic level zero). Therefore, HIT BUS[3:0] goes to b0100 which selects the patch offset field from third input of 1HOT MUX 506 (from RB 0x4), and adds this offset value (b010) to RECEIVED INST ADDR TAG (b101) to obtain b111 (the RB address of the selected register). This result is used to select the patch instruction register RB 0x7 to provide the replacement instruction as patch_data. Since the HIT indicator at the output of OR gate 530 is also asserted to a one, override MUX 210 selects patch_data instead of rom_data as the return instruction onto data bus 16.

Note that, in alternate embodiments, different configurations of digital logic can be used to implement ROM patcher 20, using, for example, different, more, or fewer gates or elements than illustrated. For example, the illustrated embodiment of FIG. 5 takes advantage of assumptions which can be made as to how certain registers or entries in bank 202 have to be configured (or of how certain registers or entries cannot be configured) to reduce the number of comparators needed to determine prefix and tag hits. For example, in an alternate embodiment, rather than using a reg_num/2 number of comparators in each of equality comparators 512 and range comparators 514, an equality and range comparator can be implemented for each register within bank 202. Also, rather than using the gating logic of AND gates 524, 526, and 528 to gate the match indicators, other embodiments may mask the appropriate registers in accordance with the configuration register to determine which registers to use for the prefix and tag comparisons to determine a hit/miss within bank 202 (e.g. by limiting the comparisons to only be performed on those registers of bank 202 which are configured as patch address registers).

Also, the above examples were described in reference to the replacement information from bank 202 used to replace information from ROM 22 as being instructions, such that bank 202 stored patches of replacement instructions. However, in alternate embodiments, the same methods and circuitry can be used to replace other types of information (such as data values) with corrected data values, in which the patch instruction registers of bank 202 would instead store patches of replacement data values instead of or in addition to replacement instructions. Therefore, the patch address entries of bank 202 may correspond more broadly to patches of replacement information, in which the replacement information can be either replacement instructions or replacement data values. In this case, a patch instruction entry or patch instruction register can instead be referred to as a patch replacement entry or patch replacement register (in which the "replacement" information can describe either an instruction or a data value, depending on what type of information is being patched). Although the descriptions above for bank 202 were done with respect to a bank of registers, any type of storage circuitry can be used. In this case, a patch address register or patch instruction register may instead be referred to as a patch address entry or patch address storage element or as a patch instruction entry or patch instruction storage element, respectively. Note also that bank 202 can include any number of entries, fewer or greater than 8 entries.

Therefore, by now it has been appreciated how patching can be implemented using an efficiently configured patch storage circuitry in which fewer patch address storage elements may be used to define patches. For example, a single patch address register may be used to define a patch with one or more patch instruction registers. In this manner, it is not necessary to have a 1:1 relationship for every patch data element. That is, not every patch instruction register requires a separate patch address register. In this manner, patching can be implemented with improved storage efficiency of a patch ROM while not increasing latency or efficiency.

As used herein, the term "bus" is used to refer to a plurality of signals or conductors which may be used to transfer one or more various types of information, such as data, addresses, control, or status. The conductors as discussed herein may be illustrated or described in reference to being a single conductor, a plurality of conductors, unidirectional conductors, or bidirectional conductors. However, different embodiments may vary the implementation of the conductors. For example, separate unidirectional conductors may be used rather than bidirectional conductors and vice versa. Also, plurality of conductors may be replaced with a single conductor that transfers multiple signals serially or in a time multiplexed manner. Likewise, single conductors carrying multiple signals may be separated out into various different conductors carrying subsets of these signals. Therefore, many options exist for transferring signals.

The terms "assert" or "set" and "negate" (or "deassert" or "clear") are used herein when referring to the rendering of a signal, status bit, or similar apparatus into its logically true or logically false state, respectively. If the logically true state is a logic level one, the logically false state is a logic level zero. And if the logically true state is a logic level zero, the logically false state is a logic level one.

Each signal described herein may be designed as positive or negative logic, where negative logic can be indicated by an asterisk (*) or "b" following the name. In the case of a negative logic signal, the signal is active low where the logically true state corresponds to a logic level zero. In the case of a positive logic signal, the signal is active high where the logically true state corresponds to a logic level one. Note that any of the signals described herein can be designed as either negative or positive logic signals. Therefore, in alternate embodiments, those signals described as positive logic signals may be implemented as negative logic signals, and those signals described as negative logic signals may be implemented as positive logic signals.

Brackets are used herein to indicate the conductors of a bus or the bit locations of a value. For example, "bus 60 [7:0]" or "conductors [7:0] of bus 60" indicates the eight lower order conductors of bus 60, and "address bits [7:0]" or "ADDRESS [7:0]" indicates the eight lower order bits of an address value. The symbol "$" or "0x" preceding a number indicates that the number is represented in its hexadecimal or base sixteen form. The symbol "%" or "b" preceding a number indicates that the number is represented in its binary or base two form.

Because the apparatus implementing the present invention is, for the most part, composed of electronic components and circuits known to those skilled in the art, circuit details will not be explained in any greater extent than that considered necessary as illustrated above, for the understanding and appreciation of the underlying concepts of the present invention and in order not to obfuscate or distract from the teachings of the present invention.

Although the invention has been described with respect to specific conductivity types or polarity of potentials, skilled artisans appreciated that conductivity types and polarities of potentials may be reversed.

Moreover, the terms "front," "back," "top," "bottom," "over," "under" and the like in the description and in the claims, if any, are used for descriptive purposes and not necessarily for describing permanent relative positions. It is understood that the terms so used are interchangeable under appropriate circumstances such that the embodiments of the invention described herein are, for example, capable of operation in other orientations than those illustrated or otherwise described herein.

Some of the above embodiments, as applicable, may be implemented using a variety of different information processing systems. For example, although FIG. 1 and the discussion thereof describe an exemplary information processing architecture, this exemplary architecture is presented merely to provide a useful reference in discussing various aspects of the invention. Of course, the description of the architecture has been simplified for purposes of discussion, and it is just one of many different types of appropriate architectures that may be used in accordance with the invention. Those skilled in the art will recognize that the boundaries between logic blocks are merely illustrative and that alternative embodiments may merge logic blocks or circuit elements or impose an alternate decomposition of functionality upon various logic blocks or circuit elements. Thus, it is to be understood that the architectures depicted herein are merely exemplary, and that in fact many other architectures can be implemented which achieve the same functionality.

Also for example, in one embodiment, the illustrated elements of system 100 are circuitry located on a single integrated circuit or within a same device. Alternatively, system 100 may include any number of separate integrated circuits or separate devices interconnected with each other. For example, ROM system 26 may be located on a same integrated circuit as processor 10 or on a separate integrated circuit or located within another peripheral or slave discretely separate from other elements of system 100.

Furthermore, those skilled in the art will recognize that boundaries between the functionality of the above described operations merely illustrative. The functionality of multiple operations may be combined into a single operation, and/or the functionality of a single operation may be distributed in additional operations. Moreover, alternative embodiments may include multiple instances of a particular operation, and the order of operations may be altered in various other embodiments.

Although the invention is described herein with reference to specific embodiments, various modifications and changes can be made without departing from the scope of the present invention as set forth in the claims below. For example, the storage circuitry which stores the patch address entry and patch data (e.g. instruction) entry can include any number of entries and is not limited to 8 entries or registers. Accordingly, the specification and figures are to be regarded in an illustrative rather than a restrictive sense, and all such modifications are intended to be included within the scope of the present invention. Any benefits, advantages, or solutions to problems that are described herein with regard to specific embodiments are not intended to be construed as a critical, required, or essential feature or element of any or all the claims.

The term "coupled," as used herein, is not intended to be limited to a direct coupling or a mechanical coupling.

Furthermore, the terms "a" or "an," as used herein, are defined as one or more than one. Also, the use of introductory phrases such as "at least one" and "one or more" in the claims should not be construed to imply that the introduction of another claim element by the indefinite articles "a" or "an" limits any particular claim containing such introduced claim element to inventions containing only one such element, even when the same claim includes the introductory phrases "one or more" or "at least one" and indefinite articles such as "a" or "an." The same holds true for the use of definite articles.

Unless stated otherwise, terms such as "first" and "second" are used to arbitrarily distinguish between the elements such terms describe. Thus, these terms are not necessarily intended to indicate temporal or other prioritization of such elements.

The following are various embodiments of the present invention. Note that any of the aspects below can be used in any combination with each other and with any of the disclosed embodiments.

In an embodiment, a data processing system includes a read-only memory (ROM) configured to receive an instruction address from a requestor of the data processing system and provide a fetched instruction from the instruction address of the ROM; and a ROM patcher. The ROM patcher includes storage circuitry configured to store a bank of entries, each entry having a corresponding bank address and is configurable as either a patch address entry or a patch replacement entry, wherein a first entry of the bank is configured as a first patch address entry storing address information indicating a first range of ROM addresses for a first patch of instructions and a plurality of entries of the bank following the first entry are configured as a plurality of patch replacement entries, each storing a replacement instruction of the first patch, and control circuitry configured to determine if the instruction address hits in the bank of entries, wherein, when the instruction address hits the address information of the first patch address entry, the replacement instruction from one of the plurality of patch replacement entries is returned to the requestor in place of the fetched instruction. In one aspect of the embodiment, each patch address entry of the bank is configured to store address information indicating a corresponding range of ROM addresses for a corresponding patch of replacement information. In a further aspect, the address information in each patch address entry of the bank includes a prefix portion of the corresponding patch and indicates a range of tags for the corresponding patch, wherein the prefix portion corresponds to a most significant bit (MSB) portion of the corresponding range of ROM addresses and the tags in the range of tags correspond to least significant bit (LSB) portions of the corresponding range of ROM addresses. In yet a further aspect, each patch address entry of the bank is followed by a corresponding set of patch replacement entries for the corresponding patch which are configured to store either replacement instructions or replacement data for each ROM address in the corresponding range of ROM addresses. In yet an even further aspect, for each patch address entry of the bank, the patch range is defined by a lower bound which indicates a tag of a starting ROM address of the corresponding patch and an upper bound which indicates a tag of an ending ROM address of the corresponding patch. In another yet even further aspect, the address information in each patch address entry of the bank further includes a patch offset which indicates a difference between the corresponding bank address of a first patch replacement entry of the corresponding set of replacement entries for the corresponding patch and a tag of a base address of the corresponding patch. In yet an even further aspect, the tag of the base address corresponds to a tag of a starting ROM address of the corresponding range of ROM addresses for the corresponding patch. In yet an even further aspect, when the instruction address hits in the first patch address entry, the one of the plurality of patch replacement entries is selected from the plurality of patch replacement entries based on the patch offset. In another further aspect, each patch replacement entry of the bank is configured to store replacement information as either a replacement instruction or a replacement data value for a corresponding patch address entry of the bank, in which the bank includes multiple patch replacement entries which store replacement information for a same corresponding patch address entry of the bank. In yet a further aspect, when multiple patch replacement entries store replacement instructions for the same corresponding patch address entry of the bank, the stored replacement instructions for the same corresponding patch address entry of the bank are consecutive instructions corresponding to consecutive address locations of the ROM. In another aspect of the above embodiment, the ROM patch further includes a multiplexer configured to receive the fetched instruction from the ROM at a first input and the replacement instruction from the one of the plurality of patch instruction entries of the bank at a second input, wherein, when the instruction address hits in the first patch address entry, the multiplexer provides the replacement instruction from the one of the plurality of patch instruction entries at the second input as a return instruction to the requestor, and when the instruction address misses in the bank of entries, the multiplexer provides the fetched instruction at the first input as the return instruction to the requestor. In another aspect, the ROM patch further includes a configuration entry configured to store a configuration indicator for each entry of the bank to indicate whether the entry is configured as a patch address entry or a patch instruction entry.

In another embodiment, a data processing system includes a read-only memory (ROM) configured to receive an instruction address from a requestor of the data processing system and provide a fetched instruction from the instruction address of the ROM; and a ROM patcher. The ROM patcher includes storage circuitry configured to store a bank of entries, each entry having a corresponding bank address, and a configuration entry configured to store a configuration indicator for each entry of the bank to indicate whether the entry is configured as a patch address entry or a patch instruction entry, wherein each patch address entry of the bank is configured to store address information which indicates a range of patchable ROM addresses for a corresponding instruction patch, and each patch address entry of the bank has a set of one or more corresponding patch instruction entries in the bank, each configured to store a corresponding replacement instruction of the corresponding instruction patch, and control circuitry configured to determine if the instruction address hits in the bank of entries by comparing the instruction address to each patch address entry of the bank, and when a hit occurs to a hit entry which is a patch address entry having at least two corresponding patch instruction entries, selecting one of the at least two corresponding patch instruction entries to return the corresponding replacement instruction in place of the fetched instruction to the requestor. In one aspect of the another embodiment, the address information in each patch address entry of the bank includes a prefix portion of a starting ROM address of the range of patchable ROM address for the corresponding instruction patch, a patch range, and a patch offset. In a further aspect, the patch offset of each patch address entry of the bank indicates a difference between the corresponding bank address of a first instruction entry of the set of one or more corresponding patch instruction entries and a tag of the starting ROM address of the range of patchable ROM addresses for the corresponding instruction patch. In yet a further aspect, the patch range of each patch address entry of the bank indicates a range of tags for the corresponding instruction patch, wherein the prefix portion corresponds to a most significant bit (MSB) portion of the starting ROM address and the tags in the range of tags correspond to least significant bit (LSB) portions of the range of patchable ROM addresses for the corresponding instruction patch. In yet a further aspect, the patch range of each patch address entry of the bank is defined by a lower bound which indicates the tag of the starting ROM address of the range of patchable ROM addresses for the corresponding patch and an upper bound which indicates a tag of an ending ROM address of the range of patchable ROM addresses for the corresponding patch. In yet an even further aspect, the control circuitry is configured to determine if the instruction address hits in the bank of entries by comparing a prefix portion of the instruction address to the ROM prefix portion of each patch address entry of the bank and comparing a tag of the instruction address to the patch range of each patch address entry of the bank. In yet an even further aspect, the control circuitry is configured to, when the hit occurs to the hit entry which is the patch address entry having at least two corresponding patch instruction entries, select the one of the at least two corresponding patch instruction entries using the patch offset of the hit entry. In another aspect of the another embodiment, for each patch address entry of the bank which has a set of multiple corresponding patch instruction entries in the bank, the corresponding replacement instructions of the multiple corresponding patch instruction entries are consecutive instructions.

## Claims

1. A data processing system, comprising:
a read-only memory (ROM) configured to receive an instruction address from a requestor of the data processing system and provide a fetched instruction from the instruction address of the ROM; and
a ROM patcher comprising:
storage circuitry configured to store a bank of entries, each entry having a corresponding bank address and is configurable as either a patch address entry or a patch replacement entry, wherein a first entry of the bank is configured as a first patch address entry storing address information indicating a first range of ROM addresses for a first patch of instructions and a plurality of entries of the bank following the first entry are configured as a plurality of patch replacement entries, each storing a replacement instruction of the first patch, and
control circuitry configured to determine if the instruction address hits in the bank of entries, wherein, when the instruction address hits the address information of the first patch address entry, the replacement instruction from one of the plurality of patch replacement entries is returned to the requestor in place of the fetched instruction.

2. The data processing system of claim 1, wherein each patch address entry of the bank is configured to store address information indicating a corresponding range of ROM addresses for a corresponding patch of replacement information.

3. The data processing system of claim 2, wherein the address information in each patch address entry of the bank includes a prefix portion of the corresponding patch and indicates a range of tags for the corresponding patch, wherein the prefix portion corresponds to a most significant bit (MSB) portion of the corresponding range of ROM addresses and the tags in the range of tags correspond to least significant bit (LSB) portions of the corresponding range of ROM addresses.

4. The data processing system of claim 3, wherein each patch address entry of the bank is followed by a corresponding set of patch replacement entries for the corresponding patch which are configured to store either replacement instructions or replacement data for each ROM address in the corresponding range of ROM addresses.

5. The data processing system of claim 4, wherein, for each patch address entry of the bank, the patch range is defined by a lower bound which indicates a tag of a starting ROM address of the corresponding patch and an upper bound which indicates a tag of an ending ROM address of the corresponding patch.

6. The data processing system of claim 4 or 5, wherein the address information in each patch address entry of the bank further includes a patch offset which indicates a difference between the corresponding bank address of a first patch replacement entry of the corresponding set of replacement entries for the corresponding patch and a tag of a base address of the corresponding patch.

7. The data processing system of claim 6, wherein the tag of the base address corresponds to a tag of a starting ROM address of the corresponding range of ROM addresses for the corresponding patch.

8. The data processing system of claim 7, wherein when the instruction address hits in the first patch address entry, the one of the plurality of patch replacement entries is selected from the plurality of patch replacement entries based on the patch offset.

9. The data processing system of any one of claims 2 to 8, wherein each patch replacement entry of the bank is configured to store replacement information as either a replacement instruction or a replacement data value for a corresponding patch address entry of the bank, in which the bank includes multiple patch replacement entries which store replacement information for a same corresponding patch address entry of the bank.

10. The data processing system of claim 9, wherein when multiple patch replacement entries store replacement instructions for the same corresponding patch address entry of the bank, the stored replacement instructions for the same corresponding patch address entry of the bank are consecutive instructions corresponding to consecutive address locations of the ROM.

11. The data processing system of any preceding claim, wherein the ROM patch further comprises:
a multiplexer configured to receive the fetched instruction from the ROM at a first input and the replacement instruction from the one of the plurality of patch instruction entries of the bank at a second input, wherein:
when the instruction address hits in the first patch address entry, the multiplexer provides the replacement instruction from the one of the plurality of patch instruction entries at the second input as a return instruction to the requestor, and
when the instruction address misses in the bank of entries, the multiplexer provides the fetched instruction at the first input as the return instruction to the requestor.

12. The data processing system of any preceding claim, wherein the ROM patch further includes a configuration entry configured to store a configuration indicator for each entry of the bank to indicate whether the entry is configured as a patch address entry or a patch instruction entry.
